# EUROPEAN PATENT APPLICATION

(11) **EP 2 348 062 A1**
(43) Date of publication of application: **27.07.2011**
(21) Application number: 09822045.2
(22) Date of filing: 21.10.2009
(51) Int. Cl.: C08G 61/08, B32B 27/00, C08J 5/00, C08K 3/00, C08L 65/00

(54) **POLYMERIZABLE COMPOSITION, MOULDED RESIN MATERIAL, AND LAMINATE**

(30) Priority: 21.10.2008 JP 2008271430; 21.10.2008 JP 2008271431
(71) Applicant: Zeon Corporation, Tokyo 100-8246 (JP)
(72) Inventor: MORI, Ryota, Tokyo 100-8246 (JP); KOJIMA, Kiyoshige, Tokyo 100-8246 (JP)
(74) Representative: Vossius & Partner
(86) International application number: PCT/JP2009/068134
(87) International publication number: WO 2010/047348

(57) **Abstract**

A polymerizable composition comprised of a cycloolefin monomer, polymerization catalyst, cross-linking agent, and reactive fluidizing agent, a cross-linkable resin shaped article obtained by bulk polymerizing the polymerizable composition, a cross-linked resin shaped article obtained by bulk polymerizing and cross-linking the polymerizable composition, and a laminate obtained by laminating at least the cross-linkable resin shaped article or the cross-linked resin shaped article.

## Description

### TECHNICAL FIELD

The present invention relates to a polymerizable composition, resin shaped article, and laminate. More particularly, it relates to a polymerizable composition, cross-linkable resin shaped article, and cross-linked resin shaped article which are useful for the production of a laminate which has an extremely small dielectric tangent in the high frequency region and is superior in wire embedding ability, heat resistance, and crack resistance in a thermal shock test and a laminate obtained using the same.

### BACKGROUND ART

In recent years, Owing to the emergence of the advanced information age, information transmission has been in trends of high speed and high frequency, and microwave communication and millimeter-wave communication have been in reality. The circuit boards in this high frequency age are being required to be made of materials with small dielectric tangents in order to reduce the transmission loss at high frequencies as much as possible. As resin materials with small dielectric tangents, cycloolefin polymers comprised of polymerized cycloolefin monomers are being looked at.

For example, Patent Document 1 discloses a method of production of a post cross-linkable thermoplastic resin characterized by bulk polymerization of a polymerizable composition containing a norbornene-based monomer, metathesis polymerization catalyst, chain transfer agent, and cross-linking agent. In the Patent Document, as a chain transfer agent, allyl methacrylate, styryl methacrylate, etc. are illustrated, further, it is described that a cross-linking aid may be mixed in the polymerizable composition, and as a cross-linking aid, p-quinonedioxime or other dioxime compounds; lauryl methacrylate, trimethylol propane trimethacrylate, or other methacrylate compounds; diallyl fumarate or other fumaric acid compounds; diallyl phthalate or other phthalic acid compounds; triallyl cyanurate or other cyanuric acid compounds; maleimide or other imide compounds etc. are illustrated.

Patent Document 2 discloses a resin shaped article obtained by impregnating into a fiber reinforcing material a polymerizable composition containing a cycloolefin monomer, metathesis polymerization catalyst, and particle-shaped metal hydroxide and metallocene compound, then performing ring-opening polymerization and a cross-linked resin composite material obtained by laminating the resin shaped article on a base material and heating it to cross-link. Specifically, it prepares a polymerizable composition containing tetracyclododecene and 2-norbornene in which a polymerization catalyst solution, a chain transfer agent constituted by styrene, a cross-linking agent constituted by di-t-butylperoxide, and a flame retardant constituted by magnesium hydroxide and ferrocene are included in combination, next impregnates that polymerizable composition in glass cloth, then heats this to 150°C to polymerize it and obtain a prepreg, and further hot presses the prepreg to obtain a cross-linked shaped article. Further, this Patent Document describes that it is possible to use, as the cycloolefin monomer, dicyclopentadiene or other monomers and, as the chain transfer agent, allyl methacrylate or a compound having two or more vinyl groups, it is possible to use, as a cross-linking aid, p-quinonedioxime or other dioxime compounds; lauryl methacrylate, trimethylol propane trimethacrylate, or other methacrylate compounds; diallyl fumarate or other fumaric acid compounds; diallyl phthalate or other phthalic acid compounds; triallyl cyanurate or other cyanuric acid compounds; maleimide or other imide compounds, etc., and that the amount of the metal hydroxide mixed in is, with respect to the cycloolefin monomer as 100 parts by weight, 50 to 300 parts by weight.

Patent Document 3 discloses a polymerizable composition containing a cyclic olefin monomer, metathesis polymerization catalyst, chain transfer agent, radical cross-linking agent, and a compound selected from a group of compounds having an alkoxyphenol structure having two or more substituents at the aromatic ring, an aryloxyphenol structure, and a catechol structure having two or more substituents at the aromatic ring. Specifically, it describes a method of production of a cross-linked resin comprising impregnating glass cloth with a reactive solution containing cyclic olefin monomers constituted by tetracyclododec-4-ene and 2-norbornene, a ruthenium-based metathesis polymerization catalyst, and a di-t-butylperoxide, performing a polymerization reaction at a 145°C temperature to produce a thermoplastic resin, then heating the thermoplastic resin to melt and cross-link. Further, it describes a method of production of a cross-linked resin comprising dissolving a cyclic olefin monomer constituted by dicyclopentadiene and a ruthenium-based metathesis polymerization catalyst in toluene, stirring this at 70°C for 1 hour, adding ethylvinylether, stopping the metathesis polymerization reaction, adding 1,3-di(2-t-butylperoxyisopropyl)benzene and 2,6-di-t-butyl-4-methoxyphenol to the solution, impregnating glass cloth with the result, vacuum drying this to produce a thermoplastic resin, then heating the thermoplastic resin to melt and cross-link. Furthermore, this Patent Document describes that it is possible to use, as the cyclic olefin monomers, cyclic olefin monomers including norbornene, norbornadiene, methylnorbomene, and dicyclopentadiene and other such cyclic olefin monomers which have at least two metathesis reactive sites in their molecules and that it is possible to use, as the cross-linking aids, trimethylolpropane trimethacrylate, ethyleneglycol diacrylate, diallyl fumarate, diallyl phthalate, triallyl cyanurate, etc.

### PRIOR ART DOCUMENTS

### PATENT DOCUMENTS

Patent Document 1: U.S. Patent Application Publication No. 2006/0211834 Specification
Patent Document 2: Japanese Patent Publication (A) No. 2006-182985
Patent Document 3: U.S. Patent Application Publication No. 2008/0125531 Specification

### DISCLOSURE OF THE INVENTION

### PROBLEM TO BE SOLVED BY THE INVENTION

However, the circuit boards fabricated using these cycloolefin polymers as base materials are still sometimes insufficient for use as high frequency board materials in terms of dielectric properties for higher frequency and higher performance applications and in terms of embedding ability for fine wires, heat resistance, crack resistance in thermal shock tests, and other properties for higher sensitivity, lower power consumption, high performance, and higher reliability applications as made clear by studies of the inventors.
An object of the present invention is to provide a polymerizable composition, cross-linkable resin shaped article, and cross-linked resin shaped article useful for production of a laminate with an extremely small dielectric tangent in the high frequency region and superior in wire embedding ability, heat resistance, and crack resistance in a thermal shock test and a laminate obtained using the same.

### MEANS FOR SOLVING THE PROBLEMS

The inventors engaged in intensive studies in consideration of this problem and as a result discovered that by using a polymerizable composition containing a cycloolefin monomer, polymerization catalyst, cross-linking agent, and benzyl methacrylate, in particular a polymerizable composition further containing a cross-linking aid constituted by trimethylolpropane trimethacrylate, a prepreg superior in fluidity at the time of being heated to melt is obtained, and further that by stacking the prepreg with other same prepregs or with other members, then heating them to cross-link, a laminate which is superior in all of the properties of dielectric properties, wire embedding ability, heat resistance, and crack resistance in a thermal shock test is obtained. Further, it was discovered that even if blending in a high dielectric filler, low linear expansion filler, nonhalogen flame retardant, or other filler in large amounts in the polymerizable composition to improve the performance of the obtained laminate, a laminate sufficiently superior in wire embedding ability, heat resistance, and crack resistance in a thermal shock test is obtained and that by using a cycloolefin monomer constituted by dicyclopentadiene or another monomer having at least one cross-linkable carbon-carbon unsaturated bond or blending allyl methacrylate or another chain transfer agent in the polymerizable composition, a laminate being more highly balanced in the properties of dielectric properties, wire embedding ability, heat resistance, and crack resistance in a thermal shock test is obtained. The inventors completed the present invention based on these discoveries.

That is, according to the present invention, there are provided
[1] A polymerizable composition which contains a cycloolefin monomer, polymerization catalyst, cross-linking agent, and reactive fluidizing agent.
[2] The polymerizable composition as set forth in [1], wherein the reactive fluidizing agent is a monofunctional compound which does not have a polymerizable carbon-carbon unsaturated bond and has a single cross-linkable carbon-carbon unsaturated bond.
[3] The polymerizable composition as set forth in [1] or [2], wherein the reactive fluidizing agent is a methacrylate compound containing a cyclic hydrocarbon group.
[4] The polymerizable composition as set forth in any one of [1] to [3], which further contains a cross-linking aid.
[5] The polymerizable composition as set forth in [4], wherein a mixing ratio of the reactive fluidizing agent and the cross-linking aid is, by weight ratio (reactive fluidizing agent/cross-linking aid), 15/85 to 70/30 in range.
[6] The polymerizable composition as set forth in [4] or [5], wherein the reactive fluidizing agent is at least one compound selected from a group comprised of benzyl methacrylate, adamantyl methacrylate, and dicyclopentanyl methacrylate and the cross-linking aid is trimethylolpropane trimethacrylate.
[7] The polymerizable composition as set forth in any one of [1] to [6], wherein the cycloolefin monomer includes a cycloolefin monomer which has at least one cross-linkable carbon-carbon unsaturated bond.
[8] The polymerizable composition as set forth in any one of [1] to [7], which further contains a filler.
[9] The polymerizable composition as set forth in [8], wherein the amount of the filler is, with respect to the cycloolefin monomer as 100 parts by weight, 50 parts by weight or more.
[10] The polymerizable composition as set forth in any one of [1] to [9], which further contains a chain transfer agent.
[11] A cross-linkable resin shaped article obtained by bulk polymerizing the polymerizable composition as set forth in any one of [1] to [10].
[12] A cross-linked resin shaped article obtained by bulk polymerizing and cross-linking the polymerizable composition as set forth in any one of [1] to [10].
[13] A laminate obtained by laminating at least a cross-linkable resin shaped article as set forth in [11] or a cross-linked resin shaped article as set forth in [12].

### EFFECTS OF THE INVENTION

According to the present invention, there are provided a polymerizable composition, cross-linkable resin shaped article, and cross-linked resin shaped article useful for production of a laminate with an extremely small dielectric tangent in the high frequency region and superior in wire embedding ability, heat resistance, and crack resistance in a thermal shock test and a laminate obtained using the same. The laminate of the present invention is superior in dielectric properties, wire embedding ability, heat resistance, and crack resistance in a thermal shock test, so can be suitably used for microwave, milliwave, and other high frequency circuit boards for communication device applications etc.

### DESCRIPTION OF EMBODIMENTS

The polymerizable composition of the present invention contains a cycloolefin monomer, polymerization catalyst, cross-linking agent, and reactive fluidizing agent.

### (Cycloolefin Monomer)

The cycloolefin monomer used in the present invention is a compound which has an alicyclic structure which is formed by carbon atoms and has one polymerizable carbon-carbon double bond in the alicyclic structure. In this Description, a "polymerizable carbon-carbon double bond" means a carbon-carbon double bond enabling chain polymerization (ring-opening polymerization). Ring-opening polymerization includes ion polymerization, radical polymerization, metathesis polymerization, and various other forms, but in the present invention, this usually means metathesis ring-opening polymerization.

As an alicyclic structure of a cycloolefin monomer, a monocyclic structure, polycyclic structure, condensation polycyclic structure, bridged ring, and combination polycyclic structures of these, etc. may be mentioned. The number of carbon atoms forming the alicyclic structure is not particularly limited, but usually is 4 to 30, preferably 5 to 20, more preferably 5 to 15.
The cycloolefin monomer may have an alkyl group, alkenyl group, alkylidene group, aryl group, or other C1 to C30 hydrocarbon group or a carboxyl group, acid anhydride group, or other polar group as a substituent, but from the viewpoint of making the obtained laminate a low dielectric tangent, it is preferable that it not have any polar group, that is, that it be comprised of only carbon atoms and hydrogen atoms.

As the cycloolefin monomer, either a monocyclic cycloolefin monomer or a polycyclic cycloolefin monomer may be used. From the viewpoint of balancing the properties of the dielectric characteristics and heat resistance of the obtained laminate to a high degree, a polycyclic cycloolefin monomer is preferable. As the polycyclic cycloolefin monomer, in particular, a norbornene-based monomer is preferable. A "norbornene-based monomer" means a cycloolefin monomer which has a norbornene ring structure in its molecule. For example, norbornenes, dicyclopentadienes, tetracyclododecenes, etc. may be mentioned.

As the cycloolefin monomer, either one which does not have a cross-linkable carbon-carbon unsaturated bond or one which has one or more cross-linkable carbon-carbon unsaturated bonds may be used. In this Description, a "cross-linkable carbon-carbon unsaturated bond" means a carbon-carbon unsaturated bond which does not participate in the ring-opening polymerization and can participate in the cross-linking reaction. A "cross-linking reaction" is a reaction which forms a cross-linked structure, condensation reaction, addition reaction, radical reaction, metathesis reaction, or various other reactions, but in the present invention, usually it means a radical cross-linking reaction or metathesis cross-linking reaction, in particular a radical cross-linking reaction. As a cross-linkable carbon-carbon unsaturated bond, a carbon-carbon unsaturated bond other than an aromatic carbon-carbon unsaturated bond, that is, an aliphatic carbon-carbon double bond or triple bond, may be mentioned. In the present invention, it usually means an aliphatic carbon-carbon double bond. The position of the unsaturated bond in the cycloolefin monomer which has at least one cross-linkable carbon-carbon unsaturated bond is not particularly limited. In addition to inside of the alicyclic structure which is formed by the carbon atoms, any position other than the alicyclic structure, for example, the terminal or inside of the side chain, is also possible. For example, the aliphatic carbon-carbon double bond can be present as a vinyl group (CH₂=CH-), vinylidene group (CH₂=C<), or vinylene group (-CH=CH-) and exhibits excellent radical cross-linking ability, so presence as a vinyl group and/or vinylidene group is preferable, while presence as a vinylidene group is more preferable.

As a cycloolefin monomer which does not have a cross-linkable carbon-carbon unsaturated bond, for example, cyclopentene, 3-methylcyclopentene, 4-methylcyclopentene, 3,4-dimethylcyclopentene, 3,5-dimethylcyclopentene, 3-chlorocyclopentene, cyclohexene, 3-methylcyclohexene, 4-methylcyclohexene, 3,4-dimethylcyclohexene, 3-chlorocyclohexene, cycloheptene, or other monocyclic cycloolefin monomer; norbornene, 5-methyl-2-norbomene, 5-ethyl-2-norbornene, 5-propyl-2-norbornene, 5,6-dimethyl-2-norbornene, 1-methyl-2-norbornene, 7-methyl-2-norbornene, 5,5,6-trimethyl-2-norbornene, 5-phenyl-2-norbornene, tetracyclododecene, 1,4,5,8-dimethano-1,2,3,4,4a,5,8,8a-octahydronaphthalene (TCD), 2-methyl-1,4,5,8-dimethano-1,2,3,4,4a,5,8,8a-octahydronaphthalene, 2-ethyl-1,4,5,8-dimethano-1,2,3,4,4a,5,8,8a-octahydronaphthalene, 2,3-dimethyl-1,4,5,8-dimethano-1,2,3,4,4a,5,8,8a-octahydronaphthalene, 2-hexyl-1,4,5,8-dimethano-1,2,3,4,4a,5,8,8a-octahydronaphthalene, 2-ethylidene-1,4,5,8-dimethano-1,2,3,4,4a,5,8,8a-octahydronaphthalene, 2-fluoro-1,4,5,8-dimethano-1,2,3,4,4a,5,8,8a-octahydronaphthalene, 1,5-dimethyl-1,4,5,8-dimethano-1,2,3,4,4a,5,8,8a-octahydronaphthalene, 2-cyclohexyl-1,4,5,8-dimethano-1,2,3,4,4a,5,8,8a-octahydronaphthalene, 2,3-dichloro-1,4,5,8-dimethano-1,2,3,4,4a,5,8,8a-octahydronaphthalene, 2-isobutyl-1,4,5,8-dimethano-1,2,3,4,4a,5,8,8a-octahydronaphthalene, 1,2-dihydrodicyclopentadiene, 5-chloro-2-norbornene, 5,5-dichloro-2-norbornene, 5-fluoro-2-norbornene, 5,5,6-trifluoro-6-trifluoromethyl-2-norbornene, 5-chloromethyl-2-norbornene, 5-methoxy-2-norbornene, 5,6-dicarboxyl-2-norbornene anhydrate, 5-dimethylamino-2-norbornene, 5-cyano-2-norbornene, or other norbornene-based monomer; may be mentioned. Preferably, it is a norbornene-based monomer which does not have a cross-linkable carbon-carbon unsaturated bond.

As the cycloolefin monomer which has at least one cross-linkable carbon-carbon unsaturated bond, for example, 3-vinylcyclohexene, 4-vinylcyclohexene, 1,3-cyclopentadiene, 1,3-cyclohexadiene, 1,4-cyclohexadiene, 5-ethyl-1,3-cyclohexadiene, 1,3-cycloheptadiene, 1,3-cyclooctadiene, or other monocyclic cycloolefin monomer; 5-ethylidene-2-norbornene, 5-methylidene-2-norbornene, 5-isopropylidene-2-norbornene, 5-vinyl-2-norbomene, 5-allyl-2-norbornene, 5,6-diethylidene-2-norbornene, dicyclopentadiene, 2,5-norbornadiene, or other norbornene-based monomer; may be mentioned. Preferably, it is a norbornene-based monomer which has at least one cross-linkable carbon-carbon unsaturated bond.
These cycloolefin monomers can be used alone or in combinations of two or more types.

As the cycloolefin monomer used in the present invention, one including a cycloolefin monomer which has at least one cross-linkable carbon-carbon unsaturated bond is preferable. If using such a cycloolefin monomer, in the obtained laminate, the crack resistance are improved, so this is preferred.
In the cycloolefin monomer which is mixed into the polymerizable composition of the present invention, the mixing ratio of a cycloolefin monomer which has at least one cross-linkable carbon-carbon unsaturated bond and a cycloolefin monomer which does not have any cross-linkable carbon-carbon unsaturated bond is suitably selected, but by weight ratio (cycloolefin monomer which has at least one cross-linkable carbon-carbon unsaturated bond/cycloolefin monomer which does not have any cross-linkable carbon-carbon unsaturated bond) is usually 5/95 to 100/0, preferably 10/90 to 90/10, more preferably 15/85 to 70/30 in range. If that mixing ratio is in that range, in the obtained laminate, the heat resistance, crack resistance in a thermal shock test, and other properties are improved to a high degree, so this is preferable.

Note that, the polymerizable composition of the present invention may contain any monomer which can be copolymerized with the above cycloolefin monomer so long as the realization of the effect of the present invention is not inhibited.

### (Polymerization Catalyst)

The polymerization catalyst which is used in the present invention is not particularly limited so long as it can polymerize the cycloolefin monomer, but the polymerizable composition of the present invention is preferably directly used for bulk polymerization in the production of the later explained cross-linkable resin shaped article. Usually, a metathesis polymerization catalyst is preferably used.

As the metathesis polymerization catalyst, a complex which enables metathesis ring-opening polymerization of the cycloolefin monomer and is comprised of a center transition metal atom around which ions, atoms, polyatomic ions, and/or compounds are bonded may be mentioned. As the transition metal atom, atoms of Group V, Group VI, and Group VIII (Long Form of the Periodic Table, same below) are used. Which of these groups of atoms to use is not particularly limited, but as atoms of Group V, preferably tantalum may be mentioned, as atoms of Group VI, preferably molybdenum and tungsten may be mentioned, and as atoms of Group VIII, preferably ruthenium and osmium may be mentioned. That is, as the metathesis polymerization catalyst which is used in the present invention, a complex having ruthenium or osmium as the center atom is preferable, while a complex having ruthenium as the center atom is more preferable. As the complex having ruthenium as the center atom, a ruthenium-carbene complex which has a carbene compound coorinate to the ruthenium is preferable. Here, a "carbene compound" is the general name for a compound having a methylene free group. It means a compound which has a bivalent carbon atom (carbine carbon) with no charge such as expressed by (>C:). A ruthenium-carbene complex is superior in catalytic activity at the time of bulk polymerization, but when subjecting the polymerizable composition of the present invention to bulk polymerization to obtain a cross-linkable resin shaped article, the obtained shaped article has little of the odor derived from unreacted monomer and a good quality shaped article with good productivity is obtained. Further, it is comparatively stable with respect to oxygen and moisture in the air thereby scarcely deactivating, so can be used even in the air.

As specific examples of the ruthenium-carbene complex, complexes of the following formula (1) or formula (2) may be mentioned.

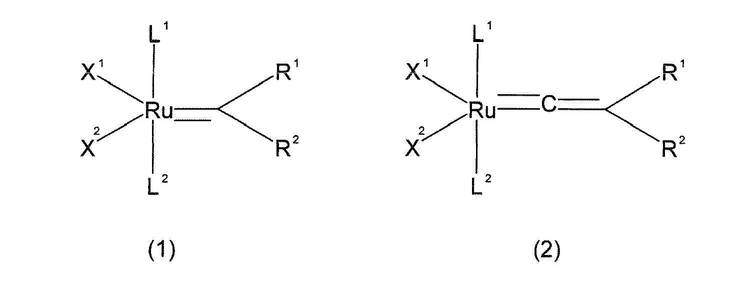

In formulas (1) and (2), R¹ and R² independently indicate a hydrogen atom, halogen atom, or cyclic or chain C1 to C20 hydrocarbon group which may contain a halogen atom, oxygen atom, nitrogen atom, sulfur atom, phosphorus atom, or silicon atom. X¹ and X² respectively independently indicate an arbitrary anionic ligand. L¹ and L² respectively independently indicate a hetero atom-containing carbene compound or neutral electron donor compound other than a hetero atom-containing carbene compound. Further, R¹ and R² may bond with each other to form an aliphatic ring or aromatic ring which may contain a hetero atom. Furthermore, R¹, R², X¹, X², L¹, and L² may bond together in any combination to form a multidentate chelating ligand.

A "hetero atom" means an atom of Group XV or Group XVI of the Periodic Table. Specifically, a nitrogen atom (N), oxygen atom (O), phosphorus atom (P), sulfur atom (S), arsenic atom (As), selenium atom (Se), etc. may be mentioned. Among these as well, from the viewpoint that a stable carbene compound is obtained, N, O, P, S, etc. are preferable, while N is particularly preferable.

As the ruthenium-carbene complex, since it is possible to obtain a good balance of mechanical strength and impact resistance of the obtained cross-linked resin shaped article and laminate, one which has, as a hetero atom-containing carbene compound, at least one carbene compound having a heterocyclic structure as a ligand is preferable. As the heterocyclic structure, an imidazoline ring structure or imidazolidine ring structure is preferable.

As the carbene compound which has a heterocyclic structure, a compound of the following formula (3) or formula (4) may be mentioned.

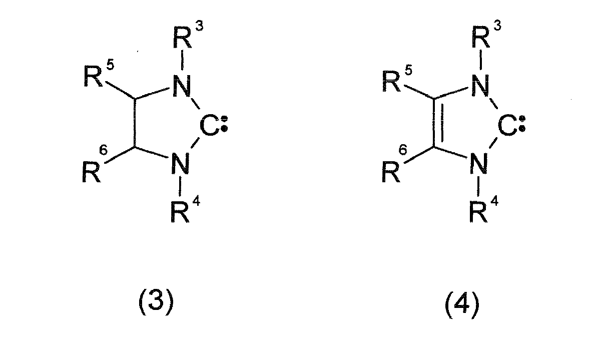

In formula (3) or formula (4), R³ to R⁶ independently indicate a hydrogen atom; halogen atom; or a cyclic or chain C1 to C20 hydrocarbon group which may contain a halogen atom, oxygen atom, nitrogen atom, sulfur atom, phosphorus atom, or silicon atom. Further, R³ to R⁶ may bond with each other in any combination to form a ring.

As the compound expressed by the formula (3) or formula (4), 1,3-dimesitylimidazolydin-2-ylidene, 1,3-di(1-adamantyl)imidazolydin-2-ylidene, 1,3-dicyclohexylimidazolydin-2-ylidene, 1,3-dimesitylocta-hydrobenzimidazole-2-ylidene, 1,3-diisopropyl-4-imidazolin-2-ylidene, 1,3-di(1-phenylethyl)-4-imidazolin-2-ylidene, 1,3-dimesityl-2,3-dihydrobenzimidazole-2-ylidene, etc. may be mentioned.

Further, in addition to the compound shown by the formula (3) or formula (4), 1,3,4-triphenyl-2,3,4,5-tetrahydro-1H-1,2,4-triazol-5-ylidene, 1,3-dicyclohexylhexahydropyridimidin-2-ylidene, N,N,N',N'-tetraisopropylformamidinylidene, 1,3,4-triphenyl-4,5-dihydro-1H-1,2,4-triazol-5-ylidene, 3-(2,6-diisopropyl phenyl)-2,3-dihydrothiazol-2-ylidene, or other hetero atom-containing carbene compounds may also be used.

In the formula (1) and formula (2), the anionic (negative ionic) ligands X¹ and X² are ligands which have a negative charge when separated from the center metal atoms. For example, a fluorine atom (F), chlorine atom (Cl), bromine atom (Br), iodine atom (I), or other halogen atoms, diketonate group, substituted cyclopentadienyl group, alkoxy group, aryloxy group, and carboxyl group, etc. may be mentioned. Among these as well, halogen atoms are preferable, and a chlorine atom is more preferable.

Further, the neutral electron donor compound may be any compound so long as a ligand which has a neutral charge when separated from the center metal. As specific examples, carbonyls, amines, pyridines, ethers, nitriles, esters, phosphines, thioethers, aromatic compounds, olefins, isocyanides, thiocyanates, etc. may be mentioned. Among these as well, phosphines, ethers, and pyridines are preferable, while trialkyl phosphine is more preferable.

As the complex compound expressed by the formula (1), benzylidene(1,3-dimesityl-4-imidazolydin-2-ylidene) (tricyclohexylphosphine)ruthenium dichloride, benzylidene(1,3-dimesityl-4,5-dibromo-4-imidazolin-2-ylidene)(tricyclohexylphosphine)ruthenium dichloride, (1,3-dimesityl-4-imidazolin-2-ylidene)(3-phenyl-1H-inden-1-ylidene) (tricyclohexylphosphine)ruthenium dichloride, (1,3-dimesitylimidazolydin-2-ylidene) (3-methyl-2-buten-1-ylidene) (tricyolopentylphosphine)ruthenium dichloride, benzylidene(1,3-dimesityloctahydrobenzimidazole-2-ylidene) (tricyclohexylphosphine) ruthenium dichloride, benzylidene[1,3-di(1-phenylethyl)-4-imidazolin-2-ylidene](tricyclohexylphosphine)ruthenium dichloride, benzylidene (1,3-dimesityl-2,3-dihydrobenzimidazole-2-ylidene)(tricyclohexylphosphine) ruthenium dichloride, benzylidene (tricyclohexylphosphine) (1,3,4-triphenyl-2,3,4,5-tetrahydro-1H-1,2,4-triazol-5-ylidene)ruthenium dichloride, (1,3-diisopropylhexahydropyridimidin-2-ylidene) (ethoxymethylene)(tricyclohexylphosphine)ruthenium dichloride, benzylidene(1,3-dimesitylimidazolydin-2-ylidene)pyridine ruthenium dichloride, (1,3-dimesitylimidazolydin-2-ylidene)(2-phenylethylidene) (tricyclohexylphosphine)ruthenium dichloride, (1,3-dimesityl-4-imidazolin-2-ylidene) (2-phenylethylidene) (tricyclohexylphosphine) ruthenium dichloride, (1,3-dimesityl-4,5-dibromo-4-imidazolin-2-ylidene) [(phenylthio)methylene] (tricyclohexylphosphine) ruthenium dichloride, (1,3-dimesityl-4,5-dibromo-4-imidazolin-2-ylidene)(2-pyrrolidon-1-ylmethylene)(tricyclohexylphosphine)ruthenium dichloride, and other ruthenium complex compounds comprising a hetero atom-containing carbene compound and a neutral electron donor compound bonded to ruthenium;

benzylidene bis(tricyclohexylphosphine)ruthenium dichloride, (3-methyl-2-buten-1-ylidene)bis(tricyclopentylphosphine)ruthenium dichloride, and other ruthenium compounds comprising two neutral electron donor compounds bonded to ruthenium;

benzylidene bis(1,3-dicyclohexylimidazolydin-2-ylidene)ruthenium dichloride, benzylidene bis(1,3-diisopropyl-4-imidazolin-2-ylidene)ruthenium dichloride, and other ruthenium complex compounds comprising two hetero atom-containing carbene compounds bonded to ruthenium; etc. may be mentioned.

As the complex compound expressed by the formula (2), (1,3-dimesitylimidazolydin-2-ylidene) (phenylvinylidene) (tricyclohexylphosphine)ruthenium dichloride, (t-butylvinylidene)(1,3-diisopropyl-4-imidazolin-2-ylidene) (tricyclopentylphosphine)ruthenium dichloride, bis(1,3-dicyclohexyl-4-imidazolin-2-ylidene)phenylvinylidene ruthenium dichloride, etc. may be mentioned.

Among these complex compounds as well, one expressed by the formula (1) and having as a ligand one compound expressed by the formula (4) is most preferable.

These ruthenium-carbene complexes may be produced by the method described in Org. Lett., 1999, vol. 1, page 953, Tetrahedron. Lett., 1999, vol. 40, page 2247, etc.

The metathesis polymerization catalyst is used alone or in combinations of two or more types. The amount of use of the metathesis polymerization catalyst is a molar ratio (metal atom in metathesis polymerization catalyst:cycloolefin monomer) of usually 1:2,000 to 1:2,000,000, preferably 1:5,000 to 1:1,000,000, more preferably 1:10,000 to 1:500,000 in range.

The metathesis polymerization catalyst if desired may be used dissolved or suspended in a small amount of an inert solvent. As the solvent, n-pentane, n-hexane, n-heptane, liquid paraffin, and mineral spirits, or other chain aliphatic hydrocarbon; cyclopentane, cyclohexane, methyl cyclohexane, dimethylcyclohexane, trimethylcyclohexane, ethylcyclohexane, diethylcyclohexane, decahydronaphthalene, dicycloheptane, tricyclodecane, hexahydroindene, and cyclooctane, or other alicyclic hydrocarbons; benzene, toluene, and xylene, or other aromatic hydrocarbons; indene, tetrahydronaphthalene, or other hydrocarbons having alicyclic and aromatic ring structures; nitromethane, nitrobenzene, acetonitrile, or other nitrogen-containing hydrocarbons; diethylether, tetrahydrofuran, or other oxygen-containing hydrocarbons; etc. may be mentioned. Among these, chain aliphatic hydrocarbons, alicyclic hydrocarbons, aromatic hydrocarbons, and hydrocarbons having alicyclic and aromatic ring structures are preferably used.

### (Cross-Linking Agent)

The cross-linking agent which is used in the present invention is used for the purpose of inducing a cross-linking reaction in a polymer (cycloolefin polymer) which is obtained by subjecting the polymerizable composition of the present invention to a polymerization reaction. Therefore, the polymer becomes a post cross-linkable thermoplastic resin. Here, "post cross-linkable" means the ability of the resin to become a cross-linked resin by progression of a cross-linking reaction by heating. The cross-linkable resin shaped article of the present invention having the above polymer as a matrix resin melts by heating and is high in viscosity, so holds its shape, while when brought into contact with any member, exhibits moldability at its surface to the shape of that member and finally cross-links to cure. The properties of the cross-linkable resin shaped article of the present invention are believed to contribute the improvement of the wire embedding ability and interlayer adhesion in a laminate obtained by laminating the cross-linkable resin shaped article of the present invention and heating, melting and cross-linking it.

In the present invention, the cross-linking agent is not particularly limited, but usually a radical generator is preferably used. As the radical generator, for example, an organic peroxide, diazo compound, nonpolar radical generator, etc. may be mentioned. Preferably, it is an organic peroxide or nonpolar radical generator.

As the organic peroxide, for example, t-butyl hydroperoxide, p-mentane hydroperoxide, and cumen hydroperoxide, or other hydroperoxides; dicumyl peroxide, t-butylcumyl peroxide, α,α'-bis(t-butylperoxy-m-isopropyl)benzene, di-t-butylperoxide, 2,5-dimethyl-2,5-di(t-butylperoxy)-3-hexine, and 2,5-dimethyl-2,5-di(t-butylperoxy)hexane, or other dialkyl peroxides; dipropionyl peroxide, and benzoyl peroxide, or other diacyl peroxides; 2,2-di(t-butylperoxy)butane, 1,1-di(t-hexylperoxy)cyclohexane, 1,1-di(t-butylperoxy)-2-methylcyclohexane, and 1,1-di(t-butylperoxy)cyclohexane, or other peroxyketals; t-butylperoxy acetate, and t-butylperoxy benzoate, or other peroxy esters; t-butylperoxyisopropyl carbonate, and di(isopropylperoxy) dicarbonate, or other peroxy carbonates; t-butyltrimethylsilyl peroxide or other alkylsilyl peroxides; 3,3,5,7,7-pentamethyl-1,2,4-trioxepane, 3,6,9-triethyl-3,6,9-trimethyl-1,4,7-triperoxonane, and 3,6-diethyl-3,6-dimethyl-1,2,4,5-tetroxane, or other cyclic peroxides may be mentioned. Among these as well, in the point of little obstruction of the polymerization reaction, dialkyl peroxides, peroxyketals, and cyclic peroxides are preferable.

As the diazo compound, for example, 4,4'-bisazidobenzal(4-methyl)cyclohexanone, and 2,6-bis(4'-azidobenzal)cyclohexanone, etc. may be mentioned.

As the nonpolar radical generator, 2,3-dimethyl-2,3-diphenylbutane, 3,4-dimethyl-3,4-diphenylhexane, 1,1,2-triphenylethane, and 1,1,1-triphenyl-2-phenylethane, etc. may be mentioned.

When using a radical generator as a cross-linking agent, the one-minute half-life temperature is suitably selected by the conditions of curing (cross-linking of the obtained polymer by subjecting the polymerizable composition of the present invention to a polymerization reaction), but is usually 100 to 300°C, preferably 150 to 250°C, more preferably 160 to 230°C in range. Here, the "one-minute half-life temperature" is the temperature at which half of the radical generator decomposes in one minute. For the one-minute half-life temperature of a radical generator, for example, refer to the catalogs or homepages of the radical generator manufacturers (for example, NOF Corporation).

The radical generator may be used alone or in combinations of two or more types. The amount of the radical generator mixed into the polymerizable composition of the present invention is, with respect to the cycloolefin monomer as 100 parts by weight, usually 0.01 to 10 parts by weight, preferably 0.1 to 10 parts by weight, more preferably 0.5 to 5 parts by weight in range.

### (Reactive Fluidizing Agent)

As explained above, the polymer obtained by subjecting the polymerizable composition of the present invention to a polymerization reaction becomes a post cross-linkable thermoplastic resin. In the present invention, the "reactive fluidizing agent" means a monofunctional compound which is present in the polymer in a substantially free state, which acts as a fluidizing agent to lower the glass transition temperature (Tg) of the polymer to raise the fluidity of the polymer at the time of heating and melting, and which, when heating and melting the cross-linkable resin shaped article of the present invention using that polymer as a matrix resin, improves the moldability of the surface of the shaped article to the shape of any member brought into contact with that surface, while, when a cross-linking reaction is induced by the cross-linking agent, participates in that reaction to exhibit binding reactivity with the polymer.

When using the polymer containing the reactive fluidizing agent as the later explained matrix resin of the cross-linkable resin shaped article, when laminating that shaped article with a circuit board etc., it is possible to easily melt laminate them by heating the shaped article. Further, in the obtained laminate, sufficient interlayer adhesion and wire embedding ability are obtained. Furthermore, the reactive fluidizing agent participates in the cross-linking reaction induced by the cross-linking agent by the heating at the time of lamination so as to exhibit a binding reactivity with the polymer, so it is guessed that along with the progress in the cross-linking reaction, the amount present in the polymer in a free state is reduced and, at the end point of the cross-linking reaction, there is substantially none present in the free state. Therefore, it does not become a factor lowering the heat resistance of the obtained laminate like a so-called plasticizer. Rather, in the obtained laminate, it exhibits the effect of raising the heat resistance and crack resistance.

As the reactive fluidizing agent which is used in the present invention, for example, a monofunctional compound which does not have a polymerizable carbon-carbon unsaturated bond (carbon-carbon double bond or triple bond) and which has one group which participates in the cross-linking reaction induced by the cross-linking agent to exhibit a binding reactivity with the polymer may be mentioned. As a polymerizable carbon-carbon unsaturated bond, for example, a polymerizable carbon-carbon double bond in the alicyclic structure of the cycloolefin monomer or a vinyl group or other aliphatic carbon-carbon unsaturated bond group which can participate in the ring-opening polymerization etc. may be mentioned. As a group which participates in the cross-linking reaction induced by the cross-linking agent to exhibit a binding reactivity with the polymer, for example, a cross-linkable carbon-carbon unsaturated bond or an organic group which exhibits such binding reactivity may be mentioned. Due to the superior binding reactivity with the obtained polymer, as the reactive fluidizing agent, a monofunctional compound which does not have a polymerizable carbon-carbon unsaturated bond and which has one cross-linkable carbon-carbon unsaturated bond is preferable. In the compound forming the reactive fluidizing agent, the cross-linkable carbon-carbon unsaturated bond is, for example, preferably present as a vinylidene group at the molecule terminal, particularly preferably is present as an isopropenyl group or methacryl group, more preferably is present as a methacryl group. As the organic group, for example, an epoxy group, isocyanate group, and sulfonate group, etc. may be mentioned.

As the reactive fluidizing agents in the present invention, due to the particularly superior binding reactivity with the obtained polymer, a methacrylate compound which has a cyclic hydrocarbon group shown in the following general formula (A) is particularly preferable.

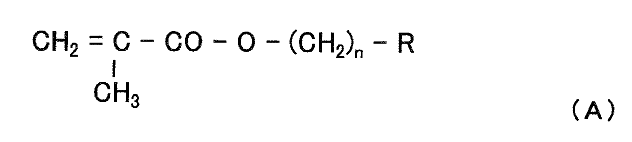

In the general formula (A), R indicates a substituted or unsubstituted C3 to C30 saturated alicyclic group or substituted or unsubstituted C6 to C30 aromatic group, while "n" is an integer of 0 to 10.
As the C3 to C30 saturated alicyclic group, for example, a cyclobutyl group, cyclopentyl group, cyclohexyl group, and cyclooctyl group, or other monocyclic group; bicyclohexyl group or other bicyclic group; tricyclo[5,2,1,0^{2,6}]decanyl group (also called dicyclopentanyl group) or other tricyclic group; adamantyl group or other tetracyclic group; etc. may be mentioned. As the saturated alicyclic group, from the viewpoint of improvement of the heat resistance of the obtained cross-linked resin shaped article or laminate, a tricyclic group or tetracyclic group is preferable, a cricyclo[5,2,1,0^{2,6}]decanyl group or adamantyl group is more preferable, and a tricyclo[5,2,1,0^{2,6}]decanyl group is particularly preferable.
As the C6 to C30 aromatic group, for example, a phenyl group or other monocyclic group; naphthyl group, biphenyl group or other bicyclic group; fluorenyl group or other tricyclic group; etc. may be mentioned. As the aromatic group, from the same viewpoint as saturated alicyclic groups, a monocyclic group is preferable, and a phenyl group is more preferable.
As the substituent of the saturated alicyclic group and aromatic group, a C3 to C11 alkyl group or C3 to C11 alkoxy group, carboxyl group, acid anhydride group, or other polar group etc. may be mentioned.
"n" is preferably 0 to 5, particularly preferably 1.

As specific examples of the compound expressed by the general formula (A), cyclohexyl methacrylate, cyclooctyl methacrylate, phenyl methacrylate, benzyl methacrylate, tolyl methacrylate, adamantyl methacrylate, and dicyclopentanyl methacrylate, etc. may be mentioned. Preferably, it is cyclohexyl methacrylate, phenyl methacrylate, benzyl methacrylate, tolyl methacrylate, adamantyl methacrylate, and dicyclopentanyl methacrylate, more preferably benzyl methacrylate, adamantyl methacrylate, and dicyclopentanyl methacrylate, furthermore preferably benzyl methacrylate.

As the reactive fluidizing agent which is used in the present invention, in addition to the above compounds, for example, lauryl methacrylate, cyclooctenyl methacrylate, tetrahydrofurfuryl methacrylate, and methoxydiethyleneglycol methacrylate, or other monofunctional compounds which have one methacryl group; isopropenyl benzene or other monofunctional compounds which have one isopropenyl group; etc. may be mentioned. Preferably, it is a monofunctional compound which has one methacryl group.
The above reactive fluidizing agent can be used alone or in combinations of two or more types. The amount of the reactive fluidizing agent mixed in may be suitably selected as desired, but is usually, with respect to the cycloolefin monomer as 100 parts by weight, 0.1 to 100 parts by weight, preferably 0.5 to 50 parts by weight, more preferably 1 to 30 parts by weight.

### (Cross-Linking Aid)

As the cross-linking aid which is used in the present invention, a polyfunctional compound which has at least two cross-linkable carbon-carbon unsaturated bonds which do not participate in the ring-opening polymerization but can participate in the cross-linking reaction induced by the cross-linking agent is preferable. The cross-linkable carbon-carbon unsaturated bond is preferably present in the compound forming the cross-linking aid as, for example, a vinylidene group present at the molecule terminal, particularly preferably is present as a isopropenyl group or methacryl group, more preferably is present as a methacryl group.

As specific examples of the cross-linking aid, p-diisopropenylbenzene, m-diisopropenylbenzene, o-diisopropenylbenzene, or other polyfunctional compounds having two isopropenyl group or other polyfunctional groups having two or more isopropenyl groups; ethylene dimethacrylate, 1,3-butylene dimethacrylate, 1,4-butylene dimethacrylate, 1,6-hexanediol dimethacrylate, polyethyleneglycol dimethacrylate, polyethyleneglycol dimethacrylate, ethyleneglycol dimethacrylate, triethyleneglycol dimethacrylate, diethyleneglycol dimethacrylate, 2,2'-bis(4-methacryloxydiethoxyphenyl)propane, or other polyfunctional compounds having two methacryl groups or trimethylolpropane trimethacrylate, pentaerythritol trimethacrylate, or other polyfunctional compounds having three methacryl groups or other polyfunctional compounds having two or more methacryl groups; etc. may be mentioned. Among these as well, as the cross-linking aid, from the viewpoint of improving the heat resistance and crack resistance of the obtained laminate, polyfunctional compounds having two or more methacryl groups are preferable. Among the polyfunctional compounds having two or more methacryl groups, in particular, trimethylolpropane trimethacrylate, pentaerythritol trimethacrylate, or other polyfunctional compounds having three methacryl groups are more preferable.

The cross-linking aid may be used alone or in combinations of two or more types. The amount of the cross-linking aid mixed into the polymerizable composition of the present invention is, with respect to the cycloolefin monomer as 100 parts by weight, usually 0.1 to 100 parts by weight, preferably 0.5 to 50 parts by weight, more preferably 1 to 30 parts by weight.

The reactive fluidizing agent and the cross-linking aid which are used in the present invention are both present in the polymer forming the cross-linkable resin shaped article of the present invention in a substantially free state and therefore exhibit a plasticizing effect on the polymer. For this reason, if heating the shaped article, the polymer will melt and exhibit a suitable fluidity. On the other hand, if continuing to heat the shaped article, a cross-linking reaction will be induced by the cross-linking agent, but each of the reactive fluidizing agent and the cross-linking aid participates in the cross-linking reaction and exhibits binding reactivity with the polymer, so it is guessed that along with the progress in the cross-linking reaction, the amount present in the polymer in a free state is reduced and, at the end point of the cross-linking reaction, there is substantially none present in the free state. In this way, the reactive fluidizing agent and the cross-linking aid have similar characteristics, but the binding reactivity with the polymer is believed to be higher in the cross-linking aid than the reactive fluidizing agent, therefore, the plasticizing effect can be expressed longer by the reactive fluidizing agent compared with the cross-linking aid. Use of a cross-linking aid is preferable from the viewpoint of raising the cross-linking density in the obtained laminate, but when heating the cross-linkable resin shaped article, if a cross-linked structure is formed earlier in the polymer forming the shaped article, a sufficient fluidity of the polymer cannot be obtained and the moldability of the surface of the cross-linkable resin shaped article to other members will fall. On this point, if jointly using a reactive fluidizing agent and a cross-linking aid, even after the plasticizing effect in the polymer due to the cross-linking aid is lost, the plasticizing effect can be expected to continue to be expressed by the reactive fluidizing agent. In the obtained laminate, the wire embedding ability, heat resistance, and crack resistance are therefore improved with an extremely good balance, so this is preferred.

When jointly mixing the reactive fluidizing agent and cross-linking aid into the polymerizable composition of the present invention, from the viewpoint of improving the wire embedding ability, heat resistance, and crack resistance with a good balance in the obtained laminate, it is preferable to use a combination of a reactive fluidizing agent (monofunctional compound), a polyfunctional compound which has two cross-linkable carbon-carbon unsaturated bonds (bifunctional compound), and a polyfunctional compound which has three cross-linkable carbon-carbon unsaturated bonds (trifunctional compound).
The mixing ratio of the reactive fluidizing agent and the cross-linking aid may be suitably selected as desired, but is usually a weight ratio (reactive fluidizing agent/cross-linking aid) of 5/95 to 90/10, preferably 10/90 to 70/30, more preferably 15/85 to 70/30 in range. If the mixing ratio is in this range, in the cross-linkable resin shaped article, the fluidity of the surface at the time of heating is improved. Further, in the laminate, the properties of the wire embedding ability, heat resistance, and crack resistance in a thermal shock test are balanced, so this is preferred.

Further, as a preferred combination of the reactive fluidizing agent and cross-linking aid in the present invention, a combination of at least one compound selected from the group comprised of benzyl methacrylate, adamantyl methacrylate, and dicyclopentanyl methacrylate (reactive fluidizing agent) and trimethylolpropane trimethacrylate (cross-linking aid) may be mentioned. According to this combination, even if there is no bifunctional compound included as a cross-linking aid, in the cross-linkable resin shaped article, the fluidity of the surface at the time of heating is improved. Further, in the laminate, the properties of the wire embedding ability, heat resistance, and crack resistance in a thermal shock test are balanced to a high degree. This is therefore extremely preferable.

The amount of the combination comprised of the reactive fluidizing agent and the cross-linking aid mixed into the polymerizable composition of the present invention (total amount of reactive fluidizing agent and cross-linking aid mixed in) is, with respect to the cycloolefin monomer as 100 parts by weight, usually 0.2 to 200 parts by weight, preferably 1 to 100 parts by weight, more preferably 2 to 60 parts by weight.

### (Polymerizable Composition)

The polymerizable composition used in the present invention includes the above cycloolefin monomer, polymerization catalyst, cross-linking agent, and reactive fluidizing agent as essential ingredients and may have added to it, as desired, not only a cross-linking aid, but also a filler, polymerization adjuster, polymerization reaction retardant, chain transfer agent, antiaging agent, and other compounding agents.

In the present invention, a filler is preferably blended into the polymerizable composition for the purpose of improving the performance of the laminate. The polymerizable composition of the present invention is lower in viscosity compared with the polymer varnish conventionally used for the production of a prepreg or laminate, which is comprised of an epoxy resin etc. dissolved in a solvent, so the filler can be easily mixed in by a high ratio. Accordingly, the obtained cross-linkable resin shaped article or laminate may contain the filler over the limit content of a conventional prepreg or laminate.

As the filler, either of an organic filler and inorganic filler may be used and may be suitably selected as desired, but usually an inorganic filler is preferably used. This inorganic filler can be classified by its properties into, for example, a high dielectric filler, low linear expansion filler, and nonhalogen flame retardant. In the present invention, the inorganic filler may be used alone or in combinations of two or more types.

A "high dielectric filler" is an inorganic filler with generally high dielectric properties. By mixing this in the polymerizable composition of the present invention, in the obtained laminate, the dielectric tangent can be made small and permittivity can be increased, so for example according to the laminate, a low loss, small device design circuit board etc. can be obtained, so this is preferred.
As the high dielectric filler, any one which is industrially used can be used without special limitation, but in particular one which has specific permittivity measured at 1 GHz and 20°C of usually 5 or more, preferably 10 or more, more preferably 15 or more is preferred. As such a high dielectric filler, for example, calcium zirconate, strontium zirconate, lead zirconate, and zirconia and other zirconium oxides; barium titanate, strontium titanate, calcium titanate, cobalt titanate, zinc titanate, and titania and other titanium oxides; etc. may be mentioned.

A "low linear expansion filler" is an inorganic filler with a generally low linear coefficient of expansion. By mixing this in the polymerizable composition of the present invention, in the obtained laminate, the mechanical strength is improved and the linear coefficient of expansion can be lowered, so this is preferred.
The linear coefficient of expansion of the low linear expansion filler is usually 15 ppm/°C or less. The linear coefficient of expansion of the low linear expansion filler can be measured by a thermal mechanical analyzer (TMA). As such a low linear expansion filler, any one which is industrially used can be used without special limitation. For example, silica, silica balloons, alumina, iron oxide, zinc oxide, magnesium oxide, stannous oxide, beryllium oxide, barium ferrite, strontium ferrite, or other inorganic oxides; calcium carbonate, magnesium carbonate, sodium hydrogencarbonate, or other inorganic carboxylates; calcium sulfate or other inorganic sulfates; talc, clay, mica, kaolin, fly ash, montmorillonite, calcium silicate, glass, glass balloons, and other inorganic silicates; etc. may be mentioned. Preferably it is silica.

A "nonhalogen flame retardant" is comprised of a flame retardant compound not containing any halogen atoms. By mixing this in the polymerizable composition of the present invention, the flame retardancy of the obtained laminate can be improved and there is no concern over the production of dioxins at the time of burning the laminate, so this is preferred. As the nonhalogen flame retardant, any one which is industrially used can be used without special limitation. For example, aluminum hydroxide, magnesium hydroxide, or other metal hydroxide flame retardant; aluminum dimethylphosphinate, aluminum diethylphosphinate, or other phosphinates; magnesium oxide, aluminum oxide, or other metal oxide flame retardants; triphenylphosphate, tricresyl phosphate, trixylenyl phosphate, cresyl diphenylphosphate, resorcinol bis(diphenyl)phosphate, bisphenol A bis(diphenyl)phosphate, bisphenol A bis(dicresyl)phosphate, or other phosphorus-containing flame retardants other than phosphinates; melamine derivatives, guanidines, isocyanules, or other nitrogen-containing flame retardants; polyammonium phosphate, melamine phosphate, polymelamine phosphate, polymelam phosphate, guanidine phosphate, and phosphazens, or other flame retardants containing both phosphorus and nitrogen; etc. may be mentioned. As nonhalogen flame retardants, metal hydroxide flame retardants, phosphinates, and phosphorus-containing flame retardants other than phosphinates are preferable. As phosphorus-containing flame retardants, tricresyl phosphate, resorcinol bis(diphenyl) phosphate, bisphenol A bis(diphenyl) phosphate, and bisphenol A bis(dicresyl) phosphate are particularly preferable.

The particle size (average particle size) of the filler which is used in the present invention may be suitably selected in accordance with desire, but the average value of the lengths in the long direction and short direction when viewing particles three-dimensionally is usually 0.001 to 50 µm, preferably 0.01 to 10 µm, more preferably 0.1 to 5 µm in range.

These fillers may be used alone or in combinations of two or more types. The amount mixed in the polymerizable composition of the present invention is, with respect to the cycloolefin monomer as 100 parts by weight, usually 50 parts by weight or more, preferably 50 to 1,000 parts by weight, more preferably 50 to 750 parts by weight, furthermore preferably 100 to 500 parts by weight in range.

A polymerization adjuster is mixed in for the purpose of controlling the polymerization activity or improving the polymerization reaction rate. For example, trialkoxy aluminum, triphenoxy aluminum, dialkoxyalkyl aluminum, alkoxydialkyl aluminum, trialkyl aluminum, dialkoxy aluminum chloride, alkoxyalkyl aluminum chloride, dialkyl aluminum chloride, trialkoxy scandium, tetraalkoxy titanium, tetraalkoxy tin, tetraalkoxy zirconium, etc. may be mentioned. These polymerization adjusters may be used alone or in combinations of two or more types. The amount of the polymerization adjuster blended is, for example, by molar ratio (metal atom in metathesis polymerization catalyst:polymerization adjuster), usually 1:0.05 to 1:100, preferably 1:0.2 to 1:20, more preferably 1:0.5 to 1:10 in range.

A polymerization reaction retardant can suppress the increase in viscosity of the polymerizable composition of the present invention. Therefore, a polymerizable composition containing a polymerization reaction retardant can be easily uniformly impregnated in a fiber reinforcing material when for example preparing a prepreg as a cross-linkable resin shaped article, so this is preferred. As the polymerization reaction retardant, it is possible to use triphenyl phosphine, tributyl phosphine, trimethyl phosphine, triethyl phosphine, dicyclohexyl phosphine, vinyldiphenyl phosphine, allyldiphenyl phosphine, triallyl phosphine, styryldiphenyl phosphine, or other phosphine compounds; aniline, pyridine, or other Lewis bases; etc. The amount mixed may be suitably adjusted in accordance with desire.

By blending a chain transfer agent in the polymerizable composition of the present invention, the moldability when heated to melt of the surface of the cross-linkable resin shaped article obtained by polymerization of the above composition can be improved. For that reason, in the laminate obtained by laminating, heating, melting, and cross-linking the cross-linkable resin shaped article obtained by using a polymerizable composition in which a chain transfer agent is mixed, the wire embedding ability and interlayer adhesion become further higher, so this is preferred. The cross-linkable resin shaped article, for example, can be melt laminated with other members. In the laminate obtained using this, the wire embedding ability, heat resistance, and crack resistance in a thermal shock test can be balanced to a high degree, so this is preferred. In this Description, "other members" mean members other than the cross-linkable resin shaped article or cross-linked resin shaped article of the present invention.

The chain transfer agent may have one or more across-linkable carbon-carbon unsaturated bonds. As specific examples of a chain transfer agent, 1-hexene, 2-hexene, styrene, vinylcyclohexane, allylamine, glycidyl acrylate, allylglycidylether, ethylvinylether, methylvinylketone, 2- (diethylamino) ethyl acrylate, 4-vinylaniline, and other chain transfer agents not having a cross-linkable carbon-carbon unsaturated bond; divinylbenzene, vinyl methacrylate, allyl methacrylate, styryl methacrylate, allyl acrylate, undecenyl methacrylate, styryl acrylate, ethyleneglycol diacrylate, and other chain transfer agents having one cross-linkable carbon-carbon unsaturated bond; allyltrivinyl silane, allylmethyldivinyl silane, and other chain transfer agents having two cross-linkable carbon-carbon unsaturated bonds, etc. may be mentioned. Among these as well, from the viewpoint of balancing the properties of the wire embedding ability, heat resistance, and crack resistance in the obtained laminate to a high degree, one having at least one cross-linkable carbon-carbon unsaturated bond is preferable, while one having one cross-linkable carbon-carbon unsaturated bond is more preferable. Among these chain transfer agents as well, a chain transfer agent which has one vinyl group and one methacryl group is preferable, while vinyl methacrylate, allyl methacrylate, styryl methacrylate, undecenyl methacrylate, etc. are particularly preferable.
These chain transfer agents may be used alone or in combinations of two or more types. The amount of the chain transfer agent which is mixed into the polymerizable composition of the present invention is, with respect to the cycloolefin monomer as 100 parts by weight, usually 0.01 to 10 parts by weight, preferably 0.1 to 5 parts by weight.

Further, mixing in, as the antiaging agent, at least one type of antiaging agent selected from the group comprising a phenol-based antiaging agent, amine-based antiaging agent, phosphorus-based antiaging agent, and sulfur-based antiaging agent does not obstruct the cross-linking reaction and can improve the heat resistance of the obtained laminate to a high degree, so this is preferred. Among these as well, a phenol-based antiaging agent and amine-based antiaging agent are preferable, while a phenol-based antiaging agent is more preferable. These antiaging agents may be used alone or in combinations of two or more types. The amount of the antiaging agent used is suitably selected as desired, but is usually, with respect to the cycloolefin monomer as 100 parts by weight, 0.0001 to 10 parts by weight, preferably 0.001 to 5 parts by weight, more preferably 0.01 to 2 parts by weight in range.

The polymerizable composition of the present invention may have other compounding agents mixed into it. As the other compounding agents, a coloring agent, photostabilizer, pigment, foam agent, etc. may be used. As the coloring agent, a dye, pigment, etc. may be used. There are various types of dyes. A known one may be suitably selected and used. These other compounding agents may be used alone or in combinations of two or more types. The amount used is suitably selected in a range not detracting from the effect of the present invention.

The polymerizable composition of the present invention can be obtained by mixing the above ingredients. As the mixing method, an ordinary method may be used. For example, this may be prepared by dissolving or dispersing a polymerization catalyst in a suitable solvent to obtain a solution (catalyst solution), separately mixing the cycloolefin monomer, cross-linking agent, and other essential ingredients and other compounding agents etc. as desired to obtain another solution (monomer solution), and adding and stirring the catalyst solution in the monomer solution.

### (Cross-Linkable Resin Shaped Article)

The cross-linkable resin shaped article of the present invention may be obtained by bulk polymerization of the polymerizable composition. As the method for bulk polymerization of the polymerizable composition to obtain the cross-linkable resin shaped article, for example, (a) the method of coating the polymerizable composition on a support member, then bulk polymerizing it, (b) the method of injecting the polymerizable composition in a mold, then bulk polymerizing it, (c) the method of impregnating the polymerizable composition in a fiber reinforcing material, then bulk polymerizing it, etc. may be mentioned.

The polymerizable composition of the present invention is low in viscosity, so with the coating in the method of (a), the coating can be performed smoothly, with the injection in the method of (b), the polymerizable composition can be made to reach the spaces of even complicated shapes quickly without causing bubbles, and with the method of (c), the polymerizable composition can be quickly and evenly impregnated in the fiber reinforcing material.

According to the method of (a), a cross-linkable resin shaped article which is a film shape or sheet-shape etc. is obtained. The thickness of the shaped article is usually 15 mm or less, preferably 5 mm or less, more preferably 0.5 mm or less, most preferably 0.1 mm or less. As the support member, for example, a film or sheet comprised of polytetrafluoroethylene, polyethylene terephthalate, polypropylene, polyethylene, polycarbonate, polyethylene naphthalate, polyarylate, nylon, or other resins; a film or sheet comprised of iron, stainless steel, copper, aluminum, nickel, chrome, gold, silver, or other metal materials; etc. may be mentioned. Among these as well, a metal foil or resin film is preferably used. The thickness of the metal foil or resin film, from the viewpoint of the work efficiency etc., is usually 1 to 150 µm, preferably 2 to 100 µm, more preferably 3 to 75 µm. As the metal foil, one with a flat surface is preferable. The surface roughness (Rz), by value measured by an AFM (atomic force microscope), is usually 10 µm or less, preferably 5 µm or less, more preferably 3 µm or less, furthermore preferably 2 µm or less. If the surface roughness of the metal foil is in this range, in the obtained high frequency circuit board, the noise, delay, transmission loss, etc. in high frequency transmission can be suppressed, so this is preferred. Further, the surface of the metal foil is preferably treated by a silane coupling agent, thiol coupling agent, titanate coupling agent, or other known coupling agent or binder etc. According to the method of (a), for example, when using copper foil as the support member, it is possible to obtain resin coated copper foil (RCC).

As the method of coating the polymerizable composition of the present invention on the support member, the spray coating method, dip coating method, roll coating method, curtain coating method, die coating method, slit coating method, or other known coating method may be mentioned.

The polymerizable composition which is coated on the support member is dried as desired and then bulk polymerized. The bulk polymerization is performed by heating the polymerizable composition at a predetermined temperature. The method of heating the polymerizable composition is not particularly limited. The method of heating by placing the polymerizable composition coated on a support member on a hot plate, the method of heating while applying pressure using a press machine (hot press), the method of pressing by heated rollers, the method of using a heating oven, etc. may be mentioned.

According to the method of (b), any shape of cross-linkable resin shaped article can be obtained. As the shape, a sheet shape, film shape, column shape, cylindrical shape, polygonal columnar shape, etc. may be mentioned.

As the mold used here, a conventionally known mold, for example, a split mold structure, that is, a mold having a core mold and a cavity mold, may be used. The polymerizable composition is injected into the cavity of these and bulk polymerization is caused. The core mold and the cavity mold are fabricated so as to form a cavity matching the shape of the targeted finished product. Further, the shape, material, size, etc. of the mold are not particularly limited. Furthermore, by preparing glass plate, metal plate, or other plate shaped molds and spacers of a predetermined thickness and injecting and polymerizing by bulk polymerization the polymerizable composition in the space formed by two plate-shaped molds straddling the spacers, it is possible to obtained a sheet-shaped or film-shaped cross-linkable shaped article.

The charging pressure (filling pressure) when charging the polymerizable composition into the cavity of the shaping mold is usually 0.01 to 10 MPa, preferably 0.02 to 5 MPa. If the charging pressure is too low, the transfer of the transfer surfaces formed at the inside circumference of the cavity tends not to be performed well, while if the charging pressure is too high, the shaping mold has to be raised in rigidity, so this is not economical. The mold clamping pressure is usually 0.01 to 10 MPa in range. As the heating method of the polymerizable composition, the method of utilizing a heating means such as an electric heater, steam, etc. placed at the shaping mold, the method of heating the shaping mold in an electric furnace, etc. may be mentioned.

The method of (c) is suitably used for obtaining a sheet-shaped or film-shaped cross-linkable resin shaped article. The obtained shaped article has a thickness of usually 0.001 to 10 mm, preferably 0.005 to 1 mm, more preferably 0.01 to 0.5 mm in range. If in this range, the shapeability at the time of lamination and the mechanical strength, toughness, etc. of the laminate are improved, so this is suitable. For example, the polymerizable composition may be impregnated into a fiber reinforcing material by coating a predetermined amount of the polymerizable composition by the spray coating method, dip coating method, roll coating method, curtain coating method, die coating method, slit coating method, or other known method on the fiber reinforcing material, placing a protective film over this if desired, and pressing from above by a roller etc. After the polymerizable composition is impregnated in the fiber reinforcing material, the impregnated material is heated to a predetermined temperature to cause the polymerizable composition to polymerize by bulk polymerization and obtain the desired cross-linkable resin shaped article. The content of the fiber reinforcing material in the cross-linkable resin shaped article is usually 10 to 90 wt%, preferably 20 to 80 wt%, more preferably 30 to 70 wt% in range. If in this range, the obtained laminate is balanced in dielectric characteristics and mechanical strength, so this is suitable.

As the fiber reinforcing material, inorganic-based and/or organic-based fiber can be used. For example, PET (polyethylene terephthalate) fiber, aramide fiber, super high molecular weight polyethylene fiber, polyamide (Nylon) fiber, liquid crystal polyester fiber, and other organic fiber; glass fiber, carbon fiber, alumina fiber, tungsten fiber, molybdenum fiber, Budene fiber, titanium fiber, steel fiber, boron fiber, silicon carbide fiber, silica fiber, and other inorganic fiber; etc. may be mentioned. Among these as well, organic fiber or glass fiber are preferable. In particular, aramide fiber, liquid crystal polyester fiber, and glass fiber are preferable. As the glass fiber, E glass, NE glass, S glass, D glass, H glass, and other glass fiber can be suitably used. These may be used alone or in combinations of two or more types. The form of the fiber reinforcing material is not particularly limited. For example, a mat, cloth, nonwoven fabric, etc. may be mentioned.

As the method of heating the impregnated material of the fiber reinforcing material impregnated with the polymerizable composition, for example, a method of placing the impregnated material on a support member and heating it by a method such as the above (a), the method of placing a fiber reinforcing material in a mold in advance and impregnating the polymerizable composition in the mold to obtain an impregnated material, then heating it by a method such as the above (b), etc. may be mentioned.

In each of the methods of (a), (b), and (c), the heating temperature for causing polymerization of the polymerizable composition is usually 30 to 250°C, preferably 50 to 200°C, more preferably 90 to 150°C in range and is usually the one-minute half-life temperature of a radical generator or less, preferably 10°C or more below the one-minute half-life temperature, more preferably 20°C or more below the one-minute half-life temperature. Further, the polymerization time may be suitably selected, but is usually 1 second to 20 minutes, preferably 10 seconds to 5 minutes. By heating the polymerizable composition under these conditions, a cross-linkable resin shaped article with little unreacted monomer is obtained, so this is preferred.

The polymer which forms the cross-linkable resin shaped article obtained in the above way does not substantially have a cross-linked structure and for example can be dissolved in toluene. The molecular weight of that polymer is a polystyrene converted weight average molecular weight measured by gel permeation chromatography (eluant: dihydrofuran) of usually 1,000 to 1,000,000, preferably 5,000 to 500,000, more preferably 10,000 to 100,000 in range.

The cross-linkable resin shaped article of the present invention is a post cross-linkable resin shaped article, but may also have part of its component resin cross-linked. For example, when performing bulk polymerization of the polymerizable composition in the mold, at the center part in the mold, sometimes dissipation of the heat of the polymerization reaction is difficult, so part of the inside of the mold becomes too high in temperature. At the high temperature part, a cross-linking reaction occurs and cross-linking results. However, if the surface part where heat easily dissipates is formed by a cross-linkable resin of a post cross-linkable type, the desired effect of the cross-linkable resin shaped article of the present invention can be sufficiently enjoyed.

The cross-linkable resin shaped article of the present invention is obtained by polymerization proceeding completely. There is no concern of a further polymerization reaction proceeding during storage. The cross-linkable resin shaped article of the present invention contains a radical generator or other cross-linking agent, but so long as not heating to the temperature causing a cross-linking reaction or more, no inconveniences such as changes in surface hardness occur and the storage stability is excellent.
The cross-linkable resin shaped article of the present invention is suitably used, for example, as a prepreg, for the production of the cross-linked resin shaped article and laminate of the present invention.

### (Cross-Linked Resin Shaped Article)

The cross-linked resin shaped article of the present invention is comprised of the polymerizable composition of the present invention which is bulk polymerized and cross-linked. This cross-linked resin shaped article is, for example, obtained by cross-linking the above cross-linkable resin shaped article. The cross-linkable resin shaped article can be cross-linked by maintaining the shaped article at a temperature where a cross-linking reaction occurs in the polymer forming the shaped article or more. The heating temperature is usually the temperature at which a cross-linking reaction is induced by the cross-linking agent or more. For example, when using a radical generator as the cross-linking agent, usually the temperature is the one-minute half-life temperature or more, preferably 5°C or more higher than the one-minute half-life temperature, more preferably 10°C or more higher than the one-minute half-life temperature. Typically, it is 100 to 300°C, preferably 150 to 250°C in range. The heating time is 0.1 to 180 minutes, preferably 0.5 to 120 minutes, more preferably 1 to 60 minutes in range. Further, by maintaining the polymerizable composition of the present invention at the temperature where the above cross-linkable resin shaped article cross-links or more, specifically, by heating it by the temperature and time described here, it becomes possible to cause the bulk polymerization of the cycloolefin monomer and the cross-linking reaction at the cycloolefin polymer occurring due to that polymerization to proceed together so as to produce the cross-linked resin shaped article of the present invention. By producing a cross-linked resin shaped article in this way, if using, in accordance with the method of the above (a), for example, a support member constituted by a copper foil, a copper clad laminate (CCL) can be obtained.

### (Laminate)

The laminate of the present invention is comprised of at least the cross-linkable resin shaped article or the cross-linked resin shaped article laminated. Two shaped articles may be continuously laminated or may be indirectly laminated with another layer between them.
As the laminate comprised of the cross-linkable resin shaped article of the present invention laminated, for example, RCC comprised of copper foil and the cross-linkable resin shaped article joined in a layer form obtained by the method of the above (a) may be mentioned. Further, as the laminate comprised of the cross-linked resin shaped article of the present invention laminated, for example, the CCL comprised of copper foil and the cross-linked resin shaped article joined in a layer form obtained in accordance with the method of the above (a) may be mentioned. In the method of the above (a), if using a support member constituted by a separately obtained cross-linked resin shaped article, it is possible to obtain a laminate of the cross-linkable resin shaped article and cross-linked resin shaped article.
Further, when the cross-linkable resin shaped article is a sheet shape or film shape, the shaped article and, if desired, the sheet-shaped or film-shaped cross-linked resin shaped article may be stacked or, furthermore, for example, the metal foil may be stacked and hot pressed for cross-linking to obtain the laminate of the present invention comprised of the cross-linked resin shaped article laminated. At that time, it is also possible to laminate the RCC, CCL, or other laminate together. The pressure at the time of hot pressing is usually 0.5 to 20 MPa, preferably 3 to 10 MPa. The hot pressing may be performed in a vacuum or reduced pressure atmosphere. The hot pressing can be performed by a known press machine having a sheet forming press mold or a press forming machine for sheet mold compounds (SMC) or bulk mold compounds (BMC).

The laminate of the present invention has a low permittivity and low dielectric tangent, that is, superior electrical properties unique to a cycloolefin polymer, has little transmission loss in the high frequency region, and is superior in wire embedding ability, heat resistance, and crack resistance in a thermal shock test, so can be suitably used as a high frequency board material having a broad range of applications.

### EXAMPLES

Below, examples and comparative examples will be used to explain the present invention in further detail, but the present invention is not limited to these examples. Note that the parts and % in the examples and comparative examples are based on weight unless particularly indicated otherwise.

The characteristics in the examples and the comparative examples were measured and evaluated in accordance with the following methods.

### (1) Dielectric Tangent

An impedance analyzer (made by Agilent Technology, Model No. E4991A) was used to measure the dielectric tangent (tanδ) at 20°C and a frequency of 1 GHz by the capacity method. This was evaluated by the following criteria.
Very good: 0.003 or less
Good: over 0.003 to 0.008
Poor: over 0.008

### (2) Wire Embedding Ability

A prepreg sheet was placed on a circuit board (test board on which 15 wires of L/S=30 µm are placed), then was hot pressed at 200°C for 10 minutes at 3 MPa to obtain a laminate. The laminate was cut at any three locations in a direction vertical to the wire direction. The obtained cut sections of the laminate were visually observed and evaluated for the wire embedding ability of the resin layer on the circuit board by the following criteria. Note that, if a "good" or "very good" evaluation, the laminate functions without problem as a high frequency board material.
Very good: no parts where wires are not embedded
Good: wires not partially embedded
Poor: wires not embedded

### (3) Heat Resistance

The laminate was cut into a 20 mm square to obtain a test piece. The test piece was made to flow for 20 seconds on a 260°C solder bath. This operation was repeated three times (n=3) using separate test pieces. The swellings of the surfaces of the test pieces were visually observed and evaluated by the following criteria.
Very good: No swelling at n=3
Good: No swelling at n=2
Poor: Swelling at n=2 or more

### (4) Crack Resistance

A laminate sample was subjected to a thermal shock test for a predetermined number of times in a -65°C to +150°C temperature range, observed for appearance, then evaluated by the following criteria. Note that, the thermal shock test was performed by a thermal shock test apparatus (made by Espec, Model TSA-71H-W).
Very good: No occurrence of cracks can be confirmed in sample after end of 500 cycles
Good: No occurrence of cracks can be confirmed in sample after end of 300 cycles
Poor: Occurrence of cracks confirmed in sample after end of 300 cycles

### Example 1

Benzylidene(1,3-dimesityl-4-imidazolydin-2-ylidene)(tricyclohexylphosphine)ruthenium dichloride in 51 parts and triphenylphosphine in 79 parts were dissolved in toluene in 952 parts to prepare a catalyst solution. Separate from this, a cycloolefin monomer constituted by tetracyclododecene (TCD) in 100 parts, a chain transfer agent constituted by styrene in 0.74 part, a cross-linking agent constituted by 3,3,5,7,7-pentamethyl-1,2,4-trioxepane (one-minute half-life temperature 205°C) in 2 parts, a reactive fluidizing agent constituted by benzyl methacrylate in 15 parts, a cross-linking aid constituted by trimethylolpropane trimethacrylate in 20 parts, a flame retardant constituted by aluminum dimethylphosphinate in 50 parts, a high dielectric filler constituted by calcium titanium in 100 parts, and a phenol-based antiaging agent constituted by 3,5-di-t-butyl-4-hydroxyanisole in 1 part were mixed to prepare a monomer solution. To this, the catalyst solution was added in a ratio of 0.12 ml with respect to the cycloolefin monomer in 100 g and stirred to prepare a polymerizable composition.

Next, the obtained polymerizable composition was impregnated into glass cloth (E glass). This was subjected to a polymerization reaction at 120°C for 5 minutes to obtain a thickness 0.15 mm prepreg (cross-linkable resin shaped article). The glass cloth content of the prepreg was 40%.
Next, six of the prepared prepreg sheets were stacked. Furthermore, thickness 12 µm F2 copper foil (silane coupling agent treated electrolytic copper foil, coarseness Rz=1,600 nm, made by Furukawa Circuit Foil) was used to sandwich the laminated prepreg sheet, then the assembly was hot pressed at 205°C for 20 minutes at 3 MPa to obtain a laminate of the cross-linked resin shaped article laminated together. The obtained laminate was evaluated for dielectric tangent, heat resistance, and crack resistance. On the other hand, the wire embedding ability was evaluated by separately obtaining a laminate by the method described in the above (2) Wire Embedding Ability and using that for evaluation. The results are shown in Table 1.

### Example 2

Except for changing the cycloolefin monomer to TCD 80 parts and dicyclopentadiene 20 parts, the same procedure was followed as in Example 1 to obtain a prepreg and laminate and evaluate the characteristics. The results are shown in Table 1.

### Example 3

Except for changing the chain transfer agent to allyl methacrylate, the same procedure was followed as in Example 1 to obtain a prepreg and laminate and evaluate the characteristics. The results are shown in Table 1.

### Example 4

Except for changing the cycloolefin monomer to TCD 80 parts and dicyclopentadiene 20 parts and changing the chain transfer agent to allyl methacrylate, the same procedure was followed as in Example 1 to obtain a prepreg and laminate and evaluate the characteristics. The results are shown in Table 1.

### Example 5

Except for changing the or benzyl methacrylate to 10 parts and the amount of trimethylolpropane trimethacrylate to 10 parts, the same procedure was followed as in Example 1 to obtain a prepreg and laminate and evaluate the characteristics. The results are shown in Table 1.

### Example 6

Except for changing the reactive fluidizing agent to adamantyl methacrylate, the same procedure was followed as in Example 1 to obtain a prepreg and laminate and evaluate the characteristics. The results are shown in Table 1.

### Example 7

Except for changing the reactive fluidizing agent to dicyclopentanyl methacrylate, the same procedure was followed as in Example 1 to obtain a prepreg and laminate and evaluate the characteristics. The results are shown in Table 1.

### [ Comparative Example 1

Except for not using the reactive fluidizing agent and cross-linking aid, the same procedure was followed as in Example 1 to obtain a prepreg and laminate and evaluate the characteristics. The results are shown in Table 1.

### Comparative Example 2

Except for not using the reactive fluidizing agent, the same procedure was followed as in Example 1 to obtain a prepreg and laminate and evaluate the characteristics. The results are shown in Table 1.

**Table 1**

| | Dielectric tangent | Wire embedding ability | Heat resistance | Crack resistance |
|---|---|---|---|---|
| Example 1 | Very good | Very good | Good | Good |
| Example 2 | Very good | Very good | Good | Very good |
| Example 3 | Good | Very good | Very good | Good |
| Example 4 | Good | Very good | Very good | Very good |
| Example 5 | Very good | Good | Good | Good |
| Example 6 | Very good | Very good | Very good | Good |
| Example 7 | Very good | Very good | Very good | Good |
| Comparative Example 1 | Very good | Poor | Poor | Poor |
| Comparative Example 2 | Very good | Poor | Good | Poor |

From Table 1, it is learned that the laminates which are obtained at Examples 1 to 7 generally exhibit a low dielectric tangent and superior wire embedding ability, heat resistance, and crack resistance. On the other hand, it was learned that the laminate of Comparative Example 1 obtained using a polymerizable composition not containing a reactive fluidizing agent and cross-linking aid is inferior in the wire embedding ability, heat resistance, and crack resistance, while the laminate of Comparative Example 2 obtained using a polymerizable composition not containing a reactive fluidizing agent is inferior in the wire embedding ability and crack resistance,

### Example 8

Except for changing the chain transfer agent to divinylbenzene 1.74 parts and not using a cross-linking aid, the same procedure was followed as in Example 1 to obtain a prepreg and laminate and evaluate the characteristics. The results are shown in Table 2.

### Example 9

Except for changing the cycloolefin monomer to TCD 80 parts and dicyclopentadiene 20 parts, the same procedure was followed as in Example 8 to obtain a prepreg and laminate and evaluate the characteristics. The results are shown in Table 2.

### Example 10

Except for changing the chain transfer agent to allyl methacrylate, the same procedure was followed as in Example 8 to obtain a prepreg and laminate and evaluate the characteristics. The results are shown in Table 2.

### Example 11

Except for changing the cycloolefin monomer to TCD 80 parts and dicyclopentadiene 20 parts and changing the chain transfer agent to allyl methacrylate, the same procedure was followed as in Example 8 to obtain a prepreg and laminate and evaluate the characteristics. The results are shown in Table 2.

### Example 12

Except for changing the amount of the benzyl methacrylate to 10 parts, the same procedure was followed as in Example 8 to obtain a prepreg and laminate and evaluate the characteristics. The results are shown in Table 2.

### Example 13

Except for changing the reactive fluidizing agent to adamantyl methacrylate, the same procedure was followed as in Example 8 to obtain a prepreg and laminate and evaluate the characteristics. The results are shown in Table 2.

### Example 14

Except for changing the reactive fluidizing agent to dicyclopentanyl methacrylate, the same procedure was followed as in Example 8 to obtain a prepreg and laminate and evaluate the characteristics. The results are shown in Table 2.

### Comparative Example 3

Except for not using benzyl methacrylate, the same procedure was followed as in Example 7 to obtain a prepreg and laminate and evaluate the characteristics. The results are shown in Table 2.

**Table 2**

| | Dielectric tangent | Wire embedding ability | Heat resistance | Crack resistance |
|---|---|---|---|---|
| Example 8 | Very good | Good | Good | Good |
| Example 9 | Very good | Good | Good | Very good |
| Example 10 | Good | Good | Very good | Good |
| Example 11 | Good | Good | Very good | Very good |
| Example 12 | Very good | Good | Very good | Good |
| Example 13 | Good | Good | Very good | Very good |
| Example 14 | Very good | Good | Good | Good |
| Comparative Example 3 | Very good | Poor | Good | Good |

From Table 2, it is learned that the laminates which are obtained at Examples 8 to 14 generally exhibit a low dielectric tangent and superior wire embedding ability, heat resistance, and crack resistance. On the other hand, it was learned that the laminate of Comparative Example 3 obtained using a polymerizable composition not containing a reactive fluidizing agent is inferior in the wire embedding ability.

## Claims

1. A polymerizable composition which contains a cycloolefin monomer, polymerization catalyst, cross-linking agent, and reactive fluidizing agent.

2. The polymerizable composition as set forth in claim 1, wherein the reactive fluidizing agent is a monofunctional compound which does not have a polymerizable carbon-carbon unsaturated bond and has a single cross-linkable carbon-carbon unsaturated bond.

3. The polymerizable composition as set forth in claim 1 or 2, wherein the reactive fluidizing agent is a methacrylate compound containing a cyclic hydrocarbon group.

4. The polymerizable composition as set forth in any one of claims 1 to 3, which further contains a cross-linking aid.

5. The polymerizable composition as set forth in claim 4, wherein a mixing ratio of the reactive fluidizing agent and the cross-linking aid is, by weight ratio (reactive fluidizing agent/cross-linking aid), 15/85 to 70/30 in range.

6. The polymerizable composition as set forth in claim 4 or 5, wherein the reactive fluidizing agent is at least one compound selected from a group comprised of benzyl methacrylate, adamantyl methacrylate, and dicyclopentanyl methacrylate and the cross-linking aid is trimethylolpropane trimethacrylate.

7. The polymerizable composition as set forth in any one of claims 1 to 6, wherein the cycloolefin monomer includes a cycloolefin monomer which has at least one cross-linkable carbon-carbon unsaturated bond.

8. The polymerizable composition as set forth in any one of claims 1 to 7, which further contains a filler.

9. The polymerizable composition as set forth in claim 8, wherein the amount of the filler is, with respect to the cycloolefin monomer as 100 parts by weight, 50 parts by weight or more.

10. The polymerizable composition as set forth in any one of claims 1 to 9, which further contains a chain transfer agent.

11. A cross-linkable resin shaped article obtained by bulk polymerizing the polymerizable composition as set forth in any one of claims 1 to 10.

12. A cross-linked resin shaped article obtained by bulk polymerizing and cross-linking the polymerizable composition as set forth in any one of claims 1 to 10.

13. A laminate obtained by laminating at least the cross-linkable resin shaped article as set forth in claim 11 or the cross-linked resin shaped article as set forth in claim 12.
